# EUROPÄISCHE PATENTSCHRIFT

(11) **EP 4 010 650 B1**
(45) Veröffentlichungstag und Bekanntmachung des Hinweises auf die Patenterteilung: **31.12.2025**
(21) Anmeldenummer: 20771418.9
(22) Anmeldetag: 06.08.2020
(51) Int. Cl.: F28D 15/00

(54) **LUFTWÄRMETAUSCHER SOWIE VERFAHREN ZU DESSEN HERSTELLUNG UND DAMIT AUSGESTATTETER ELEKTRONIKAUFBAU**
AIR HEAT EXCHANGER AND METHOD FOR PRODUCTION THEREOF AND ELECTRONIC ASSEMBLY EQUIPPED THEREWITH
ÉCHANGEUR DE CHALEUR À AIR ET SON PROCÉDÉ DE PRODUCTION, ET ENSEMBLE ÉLECTRONIQUE ÉQUIPÉ DE CE DERNIER

(30) Priorität: 08.08.2019 AT 507022019
(43) Veröffentlichungstag der Anmeldung: 15.06.2022
(73) Patentinhaber: Miba Cooling Austria GmbH & Co. KG, 4663 Laakirchen (AT)
(72) Erfinder: CUSTIC, Djenan, 8041 Graz (AT); WALLNER, Samuel, 8563 Ligist (AT); HÖSELE, Rene, 8501 Lieboch (AT)
(74) Vertreter: Burger, Hannes
(86) Internationale Anmeldenummer: PCT/AT2020/060289
(87) Internationale Veröffentlichungsnummer: WO 2021/022312

(56) Entgegenhaltungen:
- WO-A1-2015/057900
- DE-U1- 202010 011 783
- US-A1- 2010 155 030
- US-A1- 2013 056 178
- US-A1- 2014 246 176
- US-B1- 6 477 045
- US-B1- 6 889 756

## Beschreibung

Die Erfindung betrifft einen Luftwärmetauscher zur Kühlung eines Leistungselektronikbauteils wie im Oberbegriff des Anspruchs 1 definiert, und wie aus US 6,477,045B bekannt.

Aus der EP0051315A2 ist eine Ausführung eines Luftwärmetauschers bekannt. Obwohl es bereits Aufgabe der EP0051315A2 war, die Wärmeabfuhr der einzelnen Bauteile zu verbessern, wird dies in der EP0051315A2 für Bauteile mit hoher Wärmeleistung, wie etwa Leistungselektronikbauteile, immer noch ungenügend gelöst.

Aus der US 2010/0155030 A1, der US 6,889,756 B1, der US 2013/0056178 A1, der US 2014/0246176 A1, der DE 20 2010 011 783 U1 und der WO 2015/057900 A1 sind weitere Wärmetauscher bekannt.

Aufgabe der vorliegenden Erfindung war es, die Nachteile des Standes der Technik zu überwinden und einen Luftwärmetauscher zur Verfügung zu stellen, welcher eine verbesserte Wärmeabfuhr auch für Elektronikbauteile mit hoher Wärmeleistung aufweist.

Eine Möglichkeit die Wärmeabfuhr zu verbessern, wäre die Verwendung eines Flüssigkeitswärmetauschers. Flüssigkeitswärmetauscher weisen jedoch den Nachteil eines hohen Energieverbrauches für die Kühlmediumumwälzung auf. Darüber hinaus weisen Flüssigkeitswärmetauscher einen komplexen Aufbau auf, welcher eine nicht unerhebliche Fehleranfälligkeit mit sich bringt. Aus diesem Grund wird die Verwendung von Flüssigkeitswärmetauschern im vorliegenden Einsatzgebiet ausgeschlossen.

Die Aufgabe der Erfindung wird durch einen Luftwärmetauscher gemäß den Ansprüchen gelöst.

Die Erfindung betrifft einen Luftwärmetauscher zur Kühlung eines Leistungselektronikbauteils umfassend:
- eine Trägerplatte mit einem Aufnahmebereich zur Aufnahme des Leistungselektronikbauteils;
- eine Wärmetauscherplatte, welche mit der Trägerplatte gekoppelt ist, wobei durch die Trägerplatte und die Wärmetauscherplatte begrenzt zumindest ein hermetisch abgeschlossener Hohlraum zur Aufnahme eines Arbeitsmediums ausgebildet ist, wobei der Hohlraum einen Verdampfer und einen Kondensator aufweist, wobei der Verdampfer in einer Wärmetransportrichtung zum Kondensator beabstandet angeordnet ist;
- Kühlrippen, welche mit der Wärmetauscherplatte gekoppelt sind.

Die Kühlrippen des Luftwärmetauschers werden im Betrieb des Luftwärmetauschers mit Luft umströmt, wodurch die vom Leistungselektronikbauteil erzeugte Wärmemenge möglichst effizient an die Umgebung abgegeben werden kann.

Die erfindungsgemäße Ausführung des Luftwärmetauschers bringt den überraschenden Vorteil mit sich, dass durch den hermetisch abgeschlossenen Hohlraum und das darin aufgenommene Arbeitsmedium bzw. durch die erfindungsgemäße Anordnung des hermetisch abgeschlossenen Hohlraumes eine Effizienzsteigerung um 20-30 % gegenüber einem ohne Hohlraum ausgeführten Luftwärmetauscher erreicht werden kann. Diese überraschend hohe Wirkungsgradsteigerung kann insbesondere dadurch erreicht werden, dass die im Aufnahmebereich der Trägerplatte eingeleitete Wärmemenge des Leistungselektronikbauteils gleichmäßig an die Kühlrippen, welche mit der Wärmetauscherplatte gekoppelt sind, geleitet werden kann, wobei die Gesamtheit der Kühlrippen die Wärmemenge annähernd gleichermaßen an die Umgebungsluft abgeben können.

Erfindungsgemäß weisen die Trägerplatte eine Trägerplattenanschlussfläche und die Wärmetauscherplatte eine Wärmetauscherplattenanschlussfläche auf, weist wobei die Trägerplattenanschlussfläche und die Wärmetauscherplattenanschlussfläche aneinander anliegen. Dass die Trägerplattenanschlussfläche und die Wärmetauscherplattenanschlussfläche aneinander anliegen, umfasst auch jenen Zustand, wenn zwischen der Trägerplattenanschlussfläche und der Wärmetauscherplattenanschlussfläche eine Zwischenschicht, wie etwa eine Lotschicht oder eine Klebstoffschicht ausgebildet ist.

Darüber hinaus kann vorgesehen sein, dass die Trägerplattenanschlussfläche an der gegenüberliegenden Seite des Aufnahmebereiches der Trägerplatte angeordnet ist.

Weiters kann vorgesehen sein, dass die Wärmetauscherplattenanschlussfläche an der bezüglich der Kühlrippen gegenüberliegenden Seite der Wärmetauscherplatte angeordnet ist. Ferner kann vorgesehen sein, dass die Trägerplattenanschlussfläche und die Wärmetauscherplattenanschlussfläche jeweils als ebene Flächen ausgebildet sind, wobei der Hohlraum durch eine Vertiefung in der Wärmetauscherplattenanschlussfläche ausgebildet ist. Dies bringt den überraschenden Vorteil mit sich, dass der Luftwärmetauscher einen möglichst einfachen Aufbau aufweisen kann und darüber hinaus eine möglichst große Effizienz aufweisen kann. Alternativ oder zusätzlich dazu kann vorgesehen sein, dass die Vertiefung zur Bildung des Hohlraumes in der Trägerplatte angeordnet ist.

Erfindungsgemäß sind die Trägerplattenanschlussfläche und die Wärmetauscherplattenanschlussfläche durch eine stoffschlüssige Verbindung, insbesondere durch eine Vakuumlötverbindung, miteinander gekoppelt.

Durch eine derartige stoffschlüssige Verbindung kann ein dichter Abschluss des Hohlraumes erreicht werden. Darüber hinaus kann durch die Vakuumlötverbindung ein besonders dichter Abschluss des Hohlraumes bzw. eine einfache Herstellung der Verbindung zwischen der Trägerplatte und der Wärmetauscherplatte erreicht werden. Außerdem kann beim Herstellen einer Vakuumlötverbindung das Arbeitsmedium einfach in den Hohlraum eingebracht werden.

Vorteilhaft ist auch eine Ausprägung, gemäß welcher vorgesehen sein kann, dass in der Vertiefung zumindest im Bereich des Verdampfers Stege angeordnet sind, welche an der Trägerplattenanschlussfläche anliegen. Dies bringt den Vorteil mit sich, dass durch die Stege die Wärmeleitfähigkeit zwischen der Trägerplatte und der Wärmetauscherplatte verbessert werden kann, wodurch eine weitere überraschende Effizienzsteigerung des Luftwärmetauschers erreicht werden kann. Darüber hinaus können die Stege als Stützelement dienen, wodurch die Stabilität des Luftwärmetauschers bzw. die Formbeständigkeit des Hohlraumes verbessert werden kann.

Alternativ dazu kann vorgesehen sein, dass in der Vertiefung zumindest im Bereich des Verdampfers Stege angeordnet sind, welche an der Wärmetauscherplattenanschlussfläche anliegen.

Gemäß einer Weiterbildung ist es möglich, dass mehrere der Stege in einer Reihe angeordnet sind, wobei mehrere Reihen von Stegen hintereinander angeordnet sind. Dies bringt den Vorteil mit sich, dass die Effizienz des Luftwärmetauschers weiter verbessert werden kann. Weiters kann vorgesehen sein, dass die einzelnen Stege aus einer Reihe und/oder aus unterschiedlichen Reihen eine zueinander unterschiedliche Dimensionierung aufweisen und/oder dass die einzelnen Stege in unterschiedlichen Abständen zueinander angeordnet sind. Dies bringt den Vorteil mit sich, dass die Verteilung der Stege an die jeweiligen Erfordernisse der Wärmeabfuhr angepasst sind.

Insbesondere kann vorgesehen sein, dass mehrere Reihen von Stegen in Wärmetransportrichtung hintereinander angeordnet sind.

Weiters kann vorgesehen sein, dass die einzelnen Stege in Wärmetransportrichtung eine Längserstreckung aufweisen und quer zur Wärmetransportrichtung eine Quererstreckung aufweisen, wobei die Längserstreckung größer ist als die Quererstreckung. Darüber hinaus kann vorgesehen sein, dass die einzelnen Stege eine Längserstreckung zwischen 2mm und 50mm, insbesondere zwischen 4mm und 20mm, bevorzugt zwischen 6mm und 10mm aufweisen. Darüber hinaus kann vorgesehen sein, dass die einzelnen Stege eine Quererstreckung zwischen 1mm und 20mm, insbesondere zwischen 2mm und 10mm, bevorzugt zwischen 3mm und 4mm aufweisen.

Weiters kann vorgesehen sein, dass im Bereich des Kondensators zumindest ein Abstandhalter ausgebildet ist. Der Abstandhalter ist derart ausgebildet, dass die Trägerplatte am Abstandhalter anliegt. Weiters kann vorgesehen sein, dass der Abstandhalter in Wärmetransportrichtung eine Längserstreckung aufweist und quer zur Wärmetransportrichtung eine Quererstreckung aufweist, wobei die Längserstreckung größer ist als die Quererstreckung. Darüber hinaus kann vorgesehen sein, dass der Abstandhalter eine Längserstreckung zwischen 20mm und 300mm, insbesondere zwischen 50mm und 200mm, bevorzugt zwischen 120mm und 130mm aufweist. Darüber hinaus kann vorgesehen sein, dass der Abstandhalter eine Quererstreckung zwischen 1mm und 20mm, insbesondere zwischen 2mm und 15mm, bevorzugt zwischen 4mm und 8mm aufweist.

Ferner kann es zweckmäßig sein, wenn zumindest zwei Hohlräume ausgebildet sind. Dies bringt den überraschenden Vorteil mit sich, dass die Effizienz des Luftwärmetauschers gegenüber einem einzelnen größer dimensionierten Hohlraum weiter verbessert werden kann. Die einzelnen Hohlräume können hierbei unabhängig voneinander und nicht miteinander verbunden im Luftwärmetauscher angeordnet sein.

Weiters kann vorgesehen sein, dass die zumindest zwei Hohlräume nebeneinander angeordnet sind, wobei die zumindest zwei Hohlräume eine zueinander gegensinnige Wärmetransportrichtung aufweisen. Dies bringt den überraschenden Vorteil einer verbesserten Wärmeverteilung mit sich.

Darüber hinaus kann vorgesehen sein, dass in der Wärmetauscherplatte Kühlrippenaufnahmen ausgebildet sind, in welchen die Kühlrippen aufgenommen sind. Eine derartige Ausführungsform des Wärmetauschers, in welcher die Kühlrippen nicht einstückig mit der Wärmetauscherplatte ausgeformt sind, sondern gesondert ausgeformt sind und in der Wärmetauscherplatte aufgenommen sind, bringt den Vorteil mit sich, dass die Wärmetauscherplatte einfach und kostengünstig hergestellt werden kann.

In einer Alternativvariante kann vorgesehen sein, dass Kühlrippen einteilig an die Wärmetauscherplatte angeformt sind. Dies kann beispielsweise erreicht werden, wenn die Wärmetauscherplatte als Stranggussprofil ausgebildet ist.

Weiters kann vorgesehen sein, dass die Wärmetauscherplatte als Tiefziehteil ausgebildet ist. In diesem Fall können die Kühlrippen ebenfalls einstückig an die Wärmetauscherplatte angeformt sein.

Insbesondere kann vorgesehen sein, dass die Aufnahmeplatte und/oder die Wärmetauscherplatte aus Aluminium bzw. aus einer Aluminiumlegierung gebildet sind.

Weiters kann vorgesehen sein, dass die Kühlrippen zur Verwendung eines gut wärmeleitfähigen Materials, wie etwa einer Wärmeleitpaste, in der Kühlrippenaufnahme aufgenommen sind.

Die Kühlrippen können aus demselben Material gefertigt sein, wie die Wärmetauscherplatte.

Weiters kann vorgesehen sein, dass der Verdampfer im Aufnahmebereich angeordnet ist, wobei der Aufnahmebereich in Draufsicht gesehen außermittig der Trägerplatte angeordnet ist. Durch die außermittige Anordnung des Aufnahmebereiches kann eine möglichst platzsparende und effiziente Ausbildung des Luftwärmetauschers erreicht werden. Gleichzeitig kann durch die Ausbildung des Hohlraumes eine gleichmäßige Wärmespreizung auf die gesamte Fläche der Wärmetauscherplatte erreicht werden.

Gemäß einer besonderen Ausprägung ist es möglich, dass der Hohlraum den Verdampfer und mehrere der Kondensatoren aufweist, wobei ausgehend vom Verdampfer zu den Kondensatoren mehrere Wärmetransportrichtungen ausgebildet sind. Durch diese Maßnahme kann eine gleichmäßige Wärmeverteilung bzw. Wärmespreizung an der Wärmetauscherplatte erreicht werden. Somit kann die Kühlleistung des Luftwärmetauschers überraschenderweise weiter verbessert werden.

Insbesondere kann vorgesehen sein, dass der Verdampfer in Draufsicht gesehen zentral an der Trägerplatte angeordnet ist und dass die Kondensatoren um den Verdampfer herum an der Trägerplatte angeordnet sind. Beispielsweise kann der Verdampfer zentral angeordnet sein, und ein erster Kondensator in einer ersten Richtung beabstandet angeordnet sein und ein zweiter Kondensator in einer zweiten Richtung beabstandet angeordnet sein.

Entsprechend einer vorteilhaften Weiterbildung kann vorgesehen sein, dass die Trägerplatte eine Trägerplattenstärke zwischen 1mm und 10mm, insbesondere zwischen 1,5mm und 5mm, bevorzugt zwischen 2mm und 3mm aufweist.

Insbesondere kann es vorteilhaft sein, wenn die Wärmetauscherplatte eine Wärmetauscherplattenstärke zwischen 5mm und 50mm, insbesondere zwischen 15mm und 35mm, bevorzugt zwischen 24mm und 27mm aufweist.

Ferner kann vorgesehen sein, dass eine Trägerplattenstärke zwischen 5% und 40%, insbesondere zwischen 10% und 20%, bevorzugt zwischen 15% und 17% einer Wärmetauscherplattenstärke beträgt. Besonders eine derartige Aufteilung zwischen der Trägerplattenstärke und der Wärmetauscherplattenstärke bringt eine überraschende Effizienzsteigerung des Luftwärmetauschers mit sich.

Weiters kann vorgesehen sein, dass die Wärmetauscherplatte und/oder die Trägerplatte durch spanabhebende Bearbeitung, insbesondere durch Fräsen hergestellt sind. Insbesondere die Vertiefung in der Wärmetauscherplatte kann einfach durch Fräsen hergestellt werden, wobei sich hier vielfältigste Formen realisieren lassen.

In einer alternativen Ausführungsvariante kann vorgesehen sein, dass die Wärmetauscherplatte und/oder die Trägerplatte durch ein Gussverfahren, insbesondere durch ein Druckgussverfahren, hergestellt werden. In einer bevorzugten Ausführungsvariante können die Wärmetauscherplatte und/oder die Trägerplatte durch ein Aluminiumdruckgussverfahren hergestellt werden.

Darüber hinaus kann vorgesehen sein, dass die Kühlrippen derart angeordnet sind, dass die Längserstreckung der Kühlrippen in Draufsicht auf die Wärmetauscherplattenanschlussfläche gesehen quer zur Wärmetransportrichtung ausgebildet ist. Besonders bei einer derartigen Anordnung der Kühlrippen kann eine überdurchschnittliche Effizienzsteigerung des Luftwärmetauschers erreicht werden.

In einer Alternativvariante kann auch vorgesehen sein, dass die Kühlrippen derart angeordnet sind, dass die Längserstreckung der Kühlrippen in Draufsicht auf die Wärmetauscherplattenanschlussfläche gesehen längs zur Wärmetransportrichtung ausgebildet ist.

Weiters kann vorgesehen sein, dass die Kühlrippen sowohl unter dem Verdampfer, als auch unter dem Kondensator angeordnet sind. Insbesondere kann vorgesehen sein, dass in Wärmetransportrichtung gesehen die Kühlrippen gleichmäßig über einen Bereich startend vom äußersten Ende bzw. über die komplette Grundfläche des Verdampfers bis zum äußersten Ende bzw. über die komplette Grundfläche des Kondensators ausgebildet sind.

Weiters kann vorgesehen sein, dass in der Trägerplatte eine Öffnung ausgebildet ist, welche dazu ausgebildet ist, um mittels eines Sockels des Leistungselektronikbauteils verschlossen zu werden. Bei einem derartigen Ausführungsbeispiel kann der Sockel des Leistungselektronikbauteils den Hohlraum begrenzen, wodurch eine besonders effiziente Wärmeabfuhr vom Leistungselektronikbauteil erreicht werden kann. Bei einem derartigen Ausführungsbeispiel kann auch vorgesehen sein, dass die Trägerplatte und die Wärmetauscherplatte einteilig ausgebildet ist und beispielsweise in Form eines Gussteils ausgebildet ist.

In einer Weiterbildung kann vorgesehen sein, dass der Hohlraum einen Dampfströmungskanal und baulich davon beabstandet einen Flüssigkeitsrückführkanal aufweist. Dies bringt den Vorteil mit sich, dass das kondensierte Arbeitsmedium im Flüssigkeitsrückführkanal vom Kondensator zum Verdampfer rückgeführt werden kann und das verdampfte Arbeitsmedium im Dampfströmungskanal vom Verdampfer zum Kondensator gelangen kann. Dadurch kann das Arbeitsmedium in einem Kreislauf geführt werden, wodurch die Kühleffizienz überraschenderweise gesteigert werden kann, da kein Wärmeaustausch zwischen dem kondensierten Arbeitsmedium und dem verdampften Arbeitsmedium stattfindet.

Weiters kann vorgesehen sein, dass eine poröse Struktur oder ein Docht im Flüssigkeitsrückführkanal angeordnet ist. Dies bringt den Vorteil mit sich, dass die Rückführung des Arbeitsmediums verbessert werden kann.

Darüber hinaus kann vorgesehen sein, dass in einem Vertiefungsboden der Vertiefung eine Senke ausgebildet ist, welche ihren tiefsten Punkt im Bereich des Verdampfers aufweist. Dies bringt den Vorteil mit sich, dass das Arbeitsmedium in seinem flüssigen Zustand schwerkraftgebunden in den Verdampfer zurück befördert werden kann.

In einer weiteren Ausführungsvariante kann vorgesehen sein, dass in einem Hohlraum mehrere Verdampfer und/oder mehrere Kondensatoren ausgebildet sind.

Weiters kann vorgesehen sein, dass in der Trägerplatte oder in der Wärmetauscherplatte eine mit dem Hohlraum strömungsverbundene Befüllöffnung ausgebildet ist. Dies bringt den Vorteil mit sich, dass nach dem Verbinden der Trägerplatte mit der Wärmetauscherplatte via die Befüllöffnung das Arbeitsmedium in den Hohlraum eingebracht werden kann und via die Befüllöffnung der gewünschte Druck im Hohlraum eingestellt werden kann.

Darüber hinaus kann vorgesehen sein, dass die Befüllöffnung im verbauten Zustand des Luftwärmetauschers derart verpresst ist, dass sie dicht abgeschlossen ist. Dies bringt den Vorteil mit sich, dass die Befüllöffnung einfach mittels einem Pressstempel zusammengedrückt werden kann, sodass die Befüllöffnung verschlossen werden kann.

In einer Alternativvariante kann vorgesehen sein, dass die Befüllöffnung mittels eines Stopfens verschlossen ist. Der Stopfen kann hierbei eine Dichtung aufweisen.

In wieder einer weiteren Ausführungsvariante kann vorgesehen sein, dass die Befüllöffnung mittels einer Schraube, wie etwa einer Wurmschraube verschlossen ist.

Erfindungsgemäß ist ein Elektronikaufbau ausgebildet. Der Elektronikaufbau umfasst:
- einen Luftwärmetauscher;
- ein am Luftwärmetauscher angeordnetes Leistungselektronikbauteil, insbesondere einen Bipolartransistor mit isolierter Gate-Elektrode.

Der Luftwärmetauscher ist nach einer der oben genannten Ausprägungen ausgebildet.

Der erfindungsgemäße Elektronikaufbau bringt den Vorteil mit sich, dass aufgrund der Verwendung des verbesserten Luftwärmetauschers auf gleichem Bauraum ein Leistungselektronikbauteil mit erhöhter Betriebsleistung und somit erhöhter Wärmeabgabemenge verwendet werden kann. Besonders Bipolartransistoren mit isolierter Gate-Elektrode erfordern eine hohe Wärmeenergieabfuhrmenge.

Gemäß einer Weiterbildung ist es möglich, dass das Leistungselektronikbauteil im Bereich des Verdampfers am Luftwärmetauscher angeordnet ist und dass im Bereich des Kondensators ein weiteres Elektronikbauteil angeordnet ist, wobei das weitere Elektronikbauteil eine geringere Wärmeabgabeleistung aufweist als eine Wärmeabgabeleistung des Leistungselektronikbauteils. Dies bringt den Vorteil mit sich, dass mehrere Bauteile am Luftwärmetauscher angebracht werden können, wobei mittels des Luftwärmetauschers eine effiziente Kühlung aller am Luftwärmetauscher angeordneten Elektronikbauteile erreicht werden kann.

Der erfindungsgemäße Aufbau des Hohlraumes im Luftwärmetauscher wirkt wie ein Wärmerohr. In einer ersten Ausführungsvariante kann der Luftwärmetauscher, insbesondere der Hohlraum, die Funktion einer Heatpipe aufweisen. In einer zweiten Ausführungsvariante kann der Luftwärmetauscher, insbesondere der Hohlraum, die Funktion eines Zwei-Phasen-Thermosiphons aufweisen. Beide Ausführungsvarianten haben gemeinsam, dass das Arbeitsmedium im Verdampfer in den gasförmigen Zustand überführt wird und das Arbeitsmedium im gasförmigen Zustand zum Kondensator gelangt. Im Kondensator wird das Arbeitsmedium wieder in den flüssigen Zustand überführt und gelangt bei der Heatpipe durch die Dochtwirkung einer porösen Struktur und bei der Ausführung eines Zwei-Phasen-Thermosiphons durch die Schwerkraft wieder zurück in den Verdampfer.

Erfindungsgemäß ist ein Verfahren zum Herstellen eines Luftwärmetauschers, insbesondere eines Luftwärmetauschers nach einem der vorhergehenden Ansprüche vorgesehen. Das Verfahren weist folgende Verfahrensschritte auf:
- Verbinden einer Trägerplatte mit einer Wärmetauscherplatte;
- Befüllen eines Hohlraumes mit einem Arbeitsmedium via die Befüllöffnung;
- Einstellen des gewünschten Druckes im Hohlraum;
- Hermetisches verschließen des Hohlraumes durch Verpressen der Befüllöffnung.

Als Arbeitsmedium können beispielsweise Alkohole, Aceton oder auch ein sonstiges Kältemittel verwendet werden. Durch den Innendruck im inneren des Hohlraumes und die Verdampfungstemperatur des gewählten Arbeitsmediums kann eingestellt werden, bei welcher Temperatur der Luftwärmetauscher betrieben werden kann bzw. seine größte Wärmeabfuhrleistung erreicht.

Insbesondere kann vorgesehen sein, dass im Hohlraum eine poröse Struktur angeordnet ist, welche eine Kapillarwirkung aufweist. Die poröse Struktur kann beispielsweise aus einem Sintermaterial gebildet sein. In einer Alternativvariante ist es auch denkbar, dass die poröse Struktur in Form eines Dochtes, beispielsweise aus einem Stahlgeflecht ausgebildet ist, welches eine Kapillarwirkung aufweist.

Als Verdampfer bzw. Kondensator im Sinne dieses Dokumentes wird ein durch die Wärmetauscherplatte und/oder durch die Trägerplatte umschlossener Bereich verstanden. Der Verdampfer bzw. der Kondensator sind somit keine eigenständigen Bauteile, können jedoch durch eigenständige Bauteile gebildet sein.

Zum besseren Verständnis der Erfindung wird diese anhand der nachfolgenden Figuren näher erläutert.

Es zeigen jeweils in stark vereinfachter, schematischer Darstellung:
- Fig. 1: eine perspektivische Ansicht eines ersten Ausführungsbeispiels eines Luftwärmetauschers;
- Fig. 2: eine Draufsicht auf eine Wärmetauscherplattenanschlussfläche des ersten Ausführungsbeispiels des Luftwärmetauschers;
- Fig. 3: eine Draufsicht auf die Wärmetauscherplattenanschlussfläche eines zweiten Ausführungsbeispiels des Luftwärmetauschers;
- Fig. 4: eine Draufsicht auf die Wärmetauscherplattenanschlussfläche eines dritten Ausführungsbeispiels des Luftwärmetauschers;
- Fig. 5: eine perspektivische Ansicht eines weiteren Ausführungsbeispiels des Luftwärmetauschers mit einem Dampfströmungskanal und einem Flüssigkeitsrückführkanal;
- Fig. 6: eine perspektivische Ansicht eines weiteren Ausführungsbeispiels des Luftwärmetauschers mit einer Senke;
- Fig. 7: eine perspektivische Ansicht eines weiteren Ausführungsbeispiels des Luftwärmetauschers mit einem Dampfströmungskanal und einem Flüssigkeitsrückführkanal;
- Fig. 8: eine perspektivische Ansicht eines weiteren Ausführungsbeispiels des Luftwärmetauschers mit einem Hohlraum und mehreren am Hohlraum ausgebildeten Verdampfern;
- Fig. 9: eine Draufsicht auf die Wärmetauscherplattenanschlussfläche eines weiteren Ausführungsbeispiels des Luftwärmetauschers mit einem Dampfströmungskanal und einem Flüssigkeitsrückführkanal.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

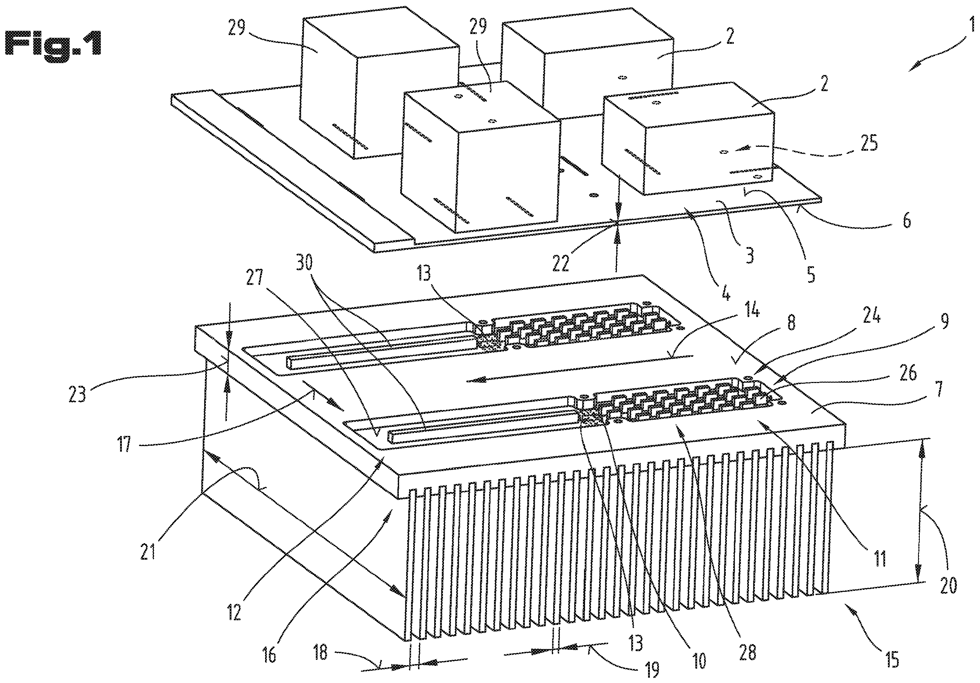

Fig. 1 zeigt eine perspektivische Ansicht eines ersten Ausführungsbeispiels eines Luftwärmetauschers 1 zur Kühlung eines Leistungselektronikbauteils 2. Ein derartiges zu kühlendes Leistungselektronikbauteil 2 kann beispielsweise ein Bipolartransistor mit isolierter Gate-Elektrode sein. Der Luftwärmetauscher 1 umfasst eine Trägerplatte 3 mit einem Aufnahmebereich 4 zur Aufnahme des Leistungselektronikbauteils 2. Der Aufnahmebereich 4 ist an einer Aufnahmeseite 5 der Trägerplatte 3 ausgebildet. An der zur Aufnahmeseite 5 gegenüberliegenden Seite der Trägerplatte 3 ist eine Trägerplattenanschlussfläche 6 ausgebildet.

Weiters umfasst der Luftwärmetauscher 1 eine Wärmetauscherplatte 7. Die Wärmetauscherplatte 7 weist eine Wärmetauscherplattenanschlussfläche 8 auf, welche im zusammengebauten Zustand des Luftwärmetauschers 1 an der Trägerplattenanschlussfläche 6 anliegt.

In Fig. 1 ist der Luftwärmetauscher 1 zur besseren Übersichtlichkeit in einer Explosionsdarstellung dargestellt, wobei die Trägerplatte 3 von der Wärmetauscherplatte 7 abgehoben dargestellt ist. Im verbauten Zustand des Luftwärmetauschers 1 sind die Trägerplattenanschlussflächen 6 und die Wärmetauscherplattenanschlussflächen 8 durch eine stoffschlüssige Verbindung miteinander gekoppelt.

Wie aus Fig. 1 weiters ersichtlich, wird erfindungsgemäß vorgesehen, dass in der Wärmetauscherplatte 7, insbesondere in der Wärmetauscherplattenanschlussfläche 8 eine Vertiefung 9 ausgebildet ist, welche im zusammengebauten Zustand der Trägerplatte 3 und der Wärmetauscherplatte 7 einen hermetisch abgeschlossenen Hohlraum 10 bildet.

Im Hohlraum 10 ist ein Verdampfer 11 und ein Kondensator 12 ausgebildet, wobei ein im Hohlraum 10 aufgenommenes Arbeitsmedium 13 bei einem Wärmeeintrag im Bereich des Verdampfers 11 verdampft und anschließend zum Kondensator 12 gelangt, wo es wieder kondensiert. Hierbei wird die spezifische Verdampfungsentalbie des Arbeitsmediums genutzt, um die Wärmeenergie vom Verdampfer 11 zum Kondensator 12 zu leiten und somit eine gleichmäßige Wärmeverteilung innerhalb der Wärmetauscherplatte 7 zu erreichen. Da das Arbeitsmedium 13 die Wärmeenergie vom Verdampfer 11 zum Kondensator 12 transportiert, kann der Weg vom Verdampfer 11 zum Kondensator 12 auch als Wärmetransportrichtung 14 gesehen werden.

Das im Kondensator 12 kondensierte Arbeitsmediums 13 kann entweder durch die Dochtwirkung einer porösen Struktur oder durch die Schwerkraft wieder zurück in den Verdampfer 11 gelangen.

An der zur Wärmetauscherplattenanschlussfläche 8 gegenüberliegenden Seite sind Kühlrippen 15 angeordnet. Insbesondere kann vorgesehen sein, dass eine Kühlrippenaufnahme 16 ausgebildet ist, in welche die Kühlrippen 15 eingesteckt sind und welche zur Übertragung der Wärmeenergie von der Wärmetauscherplatte 7 auf die Kühlrippen 15 dient.

In einer alternativen, nicht dargestellten Ausführungsvariante kann vorgesehen sein, dass die Kühlrippen 15 einstückig an die Wärmetauscherplatte 7 angeformt sind.

Wie aus Fig. 1 weiters ersichtlich, kann vorgesehen sein, dass sich die Kühlrippen 15 in einer Querrichtung 17 erstrecken. Die Querrichtung 17 kann hierbei in Draufsicht auf die Wärmetauscherplattenanschlussfläche 8 gesehen im rechten Winkel zur Wärmetransportrichtung 14 angeordnet sein.

Die einzelnen Kühlrippen 15 sind in einem Kühlrippenabstand 18 zueinander angeordnet und weisen eine Kühlrippendicke 19 auf. Insbesondere kann vorgesehen sein, dass die Kühlrippendicke 19 zwischen 20 % und 350 %, insbesondere zwischen 80 % und 200 %, bevorzugt zwischen 140 % und 160 % des Kühlrippenabstandes 18 beträgt. Weiters kann vorgesehen sein, dass die Kühlrippen 15 um einen Kühlrippenüberstand 20 gegenüber der Kühlrippenaufnahme 16 vorstehend ausgebildet sind. Der Kühlrippenüberstand 20 kann das 20 bis 25fache der Kühlrippendicke 19 betragen. Insbesondere kann vorgesehen sein, dass der Kühlrippenüberstand 20 zwischen 50 mm und 150 mm, insbesondere zwischen 70 mm und 120 mm, bevorzugt zwischen 90 mm und 95 mm beträgt.

Weiters kann vorgesehen sein, dass der Kühlrippenabstand 18 zwischen 1 mm und 20 mm, insbesondere zwischen 3 mm und 15 mm, bevorzugt zwischen 5 mm und 7 mm beträgt.

Weiters kann vorgesehen sein, dass die Kühlrippendicke 19 zwischen 1 mm und 20 mm, insbesondere zwischen 2 mm und 10 mm, bevorzugt zwischen 3 mm und 5 mm beträgt.

Weiters kann vorgesehen sein, dass die Kühlrippen 15 in deren Längserstreckung eine Kühlrippentiefe 21 aufweisen, welche sich in Querrichtung 17 erstreckt. Die Kühlrippentiefe 21 kann zwischen 100 mm und 500 mm, insbesondere zwischen 300 mm und 400 mm, bevorzugt zwischen 250 mm und 350 mm betragen.

Die Trägerplatte 3 kann eine Trägerplattenstärke 22 aufweisen. Die Wärmetauscherplatte 7 weist eine Wärmetauscherplattenstärke 23 auf.

Weiters kann vorgesehen sein, dass in der Wärmetauscherplatte 7, insbesondere im Bereich des Verdampfers 11, Gewindeelemente 24 ausgebildet sind, welche zur Aufnahme von Befestigungsschrauben für die Leistungselektronikbauteile 2 dienen. Die Gewindeelemente 24 können mit entsprechenden Durchgangslöchern 25 in der Trägerplatte 3 korrespondieren. Durch eine derartige Kombination von Gewindeelementen 24 und Durchgangslöchern 25 kann erreicht werden, dass die im Vergleich zur Trägerplattenstärke 22 größere Wärmetauscherplattenstärke 23 zur sicheren und haltbaren Aufnahme einer Befestigungsschraube genutzt werden kann.

Die Vertiefung 9 der Wärmetauscherplatte 7 erstreckt sich ausgehend von der Wärmetauscherplattenanschlussfläche 8 zu einem Vertiefungsboden 27.

Wie aus Fig. 1 weiters ersichtlich, wird erfindungsgemäß vorgesehen, dass im Bereich des Verdampfers 11 ein oder mehrere Stege 26 angeordnet sind, welche sich zwischen dem Vertiefungsboden 27 der Vertiefung 9 und der Wärmetauscherplattenanschlussfläche 8 erstrecken. Die Stege 26 dienen zur besseren Wärmeübertragung von der Trägerplatte 3 in den Verdampfer 11. Insbesondere ist vorgesehen, dass die Stege 26 im Zusammengebauten Zustand des Luftwärmetauschers 1 an der Trägerplattenanschlussfläche 6 der Trägerplatte 3 anliegen.

Wie aus Fig. 1 weiters ersichtlich, kann vorgesehen sein, dass die Stege 26 jeweils in einer Reihe 28 angeordnet sind, wobei mehrere Reihen 28 von Stegen 26 in Wärmetransportrichtung 14 gesehen hintereinander angeordnet sein können.

Weiters kann vorgesehen sein, dass im Bereich des Kondensators 12 weitere Elektronikbauteile 29 an der Trägerplatte 3 angeordnet sind.

Wie aus Fig. 1 weiters ersichtlich, kann vorgesehen sein, dass im Bereich des Kondensators ein Abstandhalter 30 ausgebildet ist. Der Abstandhalter 30 kann zur Abstützung der Trägerplatte 3 im Bereich des Kondensators 12 dienen.

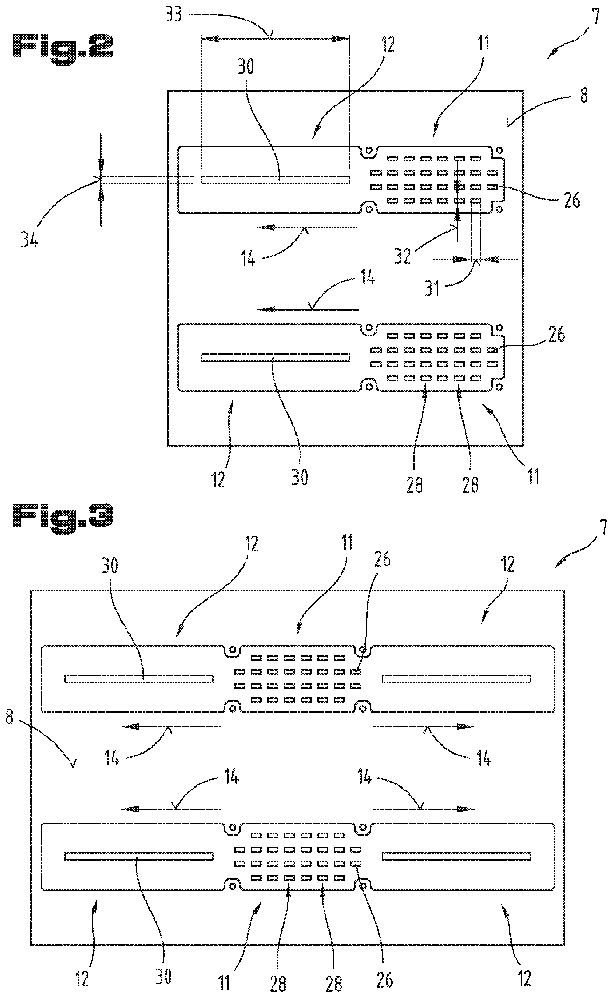

Fig. 2 zeigt die Wärmetauscherplatte 7 in einer Draufsicht auf die Wärmetauscherplattenanschlussfläche 8, wobei wiederum für gleiche Teile gleiche Bezugszeichen bzw. Bauteilbezeichnungen wie in der vorangegangenen Fig. 1 verwendet werden. Um unnötige Wiederholungen zu vermeiden, wird auf die detaillierte Beschreibung in der vorangegangenen Fig. 1 hingewiesen bzw. Bezug genommen.

Wie aus Fig. 2 ersichtlich, weisen die Stege 26 jeweils eine Längserstreckung 31 und eine Quererstreckung 32 auf. Auch der Abstandhalter 30 weist eine Längserstreckung 33 und eine Quererstreckung 34 auf.

In der Fig. 3 ist eine weitere und gegebenenfalls für sich eigenständige Ausführungsform des Luftwärmetauschers 1 gezeigt, wobei wiederum für gleiche Teile gleiche Bezugszeichen bzw. Bauteilbezeichnungen wie in den vorangegangenen Figuren 1 und 2 verwendet werden. Um unnötige Wiederholungen zu vermeiden, wird auf die detaillierte Beschreibung in den vorangegangenen Figuren 1 und 2 hingewiesen bzw. Bezug genommen.

Fig. 3 zeigt den Luftwärmetauscher 1 in einer Ansicht wie sie auch in Fig. 2 gewählt wurde. Wie aus Fig. 3 ersichtlich, kann vorgesehen sein, dass der Verdampfer 11 zentral an der Wärmetauscherplatte 7 ausgebildet ist und dass beiderseits des Verdampfers 11 ein Kondensator 12 ausgebildet ist. Somit stellt sich im Betrieb des Luftwärmetauschers 1 ausgehend vom Verdampfer 11 eine erste Wärmetransportrichtung 14 und eine zweite Wärmetransportrichtung 14 ein, welche jeweils vom Verdampfer 11 zum Kondensator 12 erfolgt. Durch diese Maßnahme kann die mögliche Wärmeabfuhr verbessert werden, da die Wärmeabfuhr in unterschiedliche Richtungen erfolgen kann.

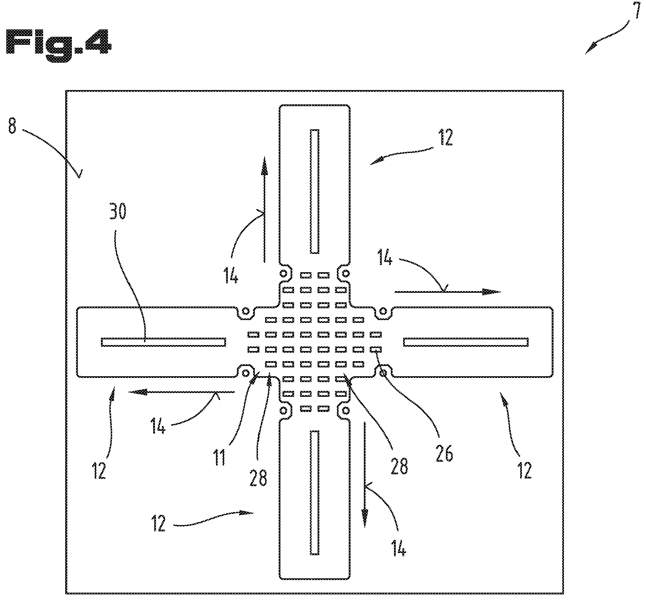

In der Fig. 4 ist eine weitere und gegebenenfalls für sich eigenständige Ausführungsform des Luftwärmetauschers 1 gezeigt, wobei wiederum für gleiche Teile gleiche Bezugszeichen bzw. Bauteilbezeichnungen wie in den vorangegangenen Figuren 1 bis 3 verwendet werden. Um unnötige Wiederholungen zu vermeiden, wird auf die detaillierte Beschreibung in den vorangegangenen Figuren 1 bis 3 hingewiesen bzw. Bezug genommen.

Wie aus Fig. 4 ersichtlich, kann vorgesehen sein, dass nicht nur einander gegenüberliegend zwei Kondensatoren 12 ausgebildet sind, sondern dass an den Verdampfer 11 mehrere Kondensatoren 12, insbesondere vier Kondensatoren 12 anschließen, welche beispielsweise sternförmig ausgebildet sein können. Hierbei kann der Verdampfer 11 beispielsweise im Zentrum der Wärmetauscherplatte 7 angeordnet sein.

Natürlich können in einer weiteren Ausführungsvariante auch drei oder mehr als vier Kondensatoren 12 sternförmig um den Verdampfer 11 angeordnet sein.

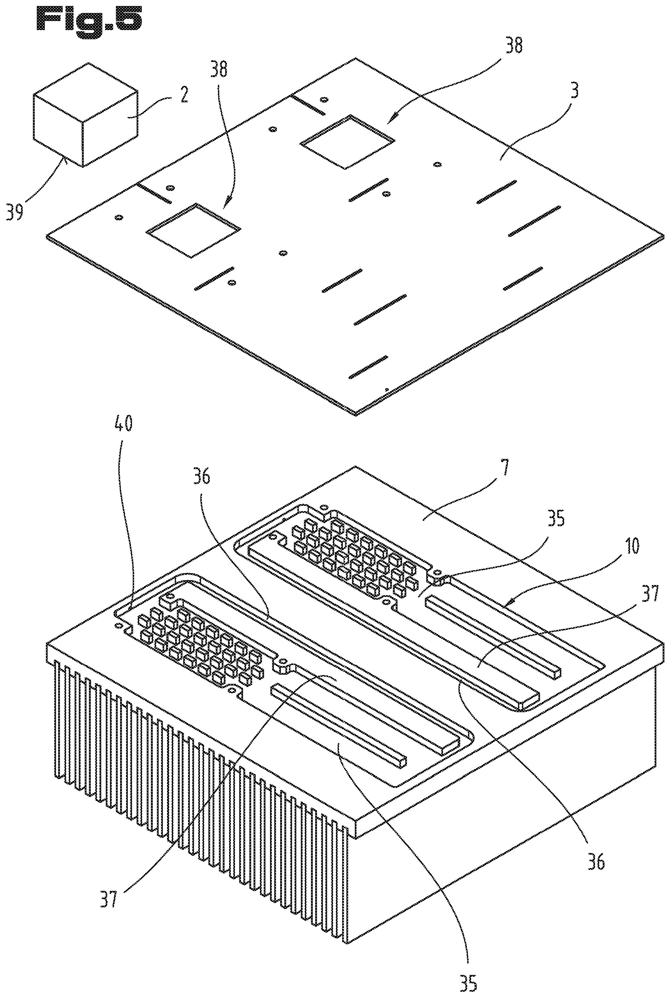

Die Figuren 5 bis 9 zeigen jeweils ein weiteres Ausführungsbeispiel des Luftwärmetauschers 1, wobei wiederum für gleiche Teile gleiche Bezugszeichen bzw. Bauteilbezeichnungen wie in den jeweils vorangegangenen Figuren verwendet werden. Um unnötige Wiederholungen zu vermeiden, wird auf die detaillierte Beschreibung in der vorangegangenen Fig. 1 hingewiesen bzw. Bezug genommen.Wie aus Fig. 5 ersichtlich, kann vorgesehen sein, dass der Hohlraum 10 einen Dampfströmungskanal 35 und baulich davon getrennt einen Flüssigkeitsrückführkanal 36 aufweist. Zwischen dem Dampfströmungskanal 35 und dem Flüssigkeitsrückführkanal 36 kann ein Trennsteg 37 angeordnet sein.

Aus Fig. 5 ist weiters ersichtlich, dass vorgesehen sein kann, dass in der Trägerplatte 3 eine Öffnung 38 ausgebildet ist, welche in jenem Bereich angeordnet ist, in welchem das Leistungselektronikbauteil 2 installiert wird. Somit kann ein Sockel 39 des Leistungselektronikbauteil 2 im verbauten Zustand die Öffnung 38 verschließen und somit auf die Öffnung 38 aufgesetzt sein, oder in die Öffnung 38 eingesetzt sein. Dadurch kann der Sockel 39 des Leistungselektronikbauteils 2 gleichzeitig eine Begrenzung für den Hohlraum 10 darstellen. Durch diese Maßnahme kann die Wärmeenergie möglichst effizient vom Leistungselektronikbauteil 2 auf das im Hohlraum 10 aufgenommene Arbeitsmedium 13 übertragen werden.

Wie aus Fig. 5 weiters ersichtlich, kann vorgesehen sein, dass eine Befüllöffnung 40 ausgebildet ist, welche zum Befüllen des Hohlraumes 10 mit dem Arbeitsmedium 13 dient. Die Befüllöffnung 40 kann beispielsweise in einer Seitenfläche des Hohlraumes 10 angeordnet sein. Weiters kann vorgesehen sein, dass die Befüllöffnung 40 in der Wärmetauscherplatte 7 ausgebildet ist.

Wenn das Leistungselektronikbauteil 2 zum Abschließen des Hohlraumes 10 dient, kann auch vorgesehen sein, dass die Stege 26 direkt am Sockels 39 des Leistungselektronikbauteils 2 angeordnet sind.

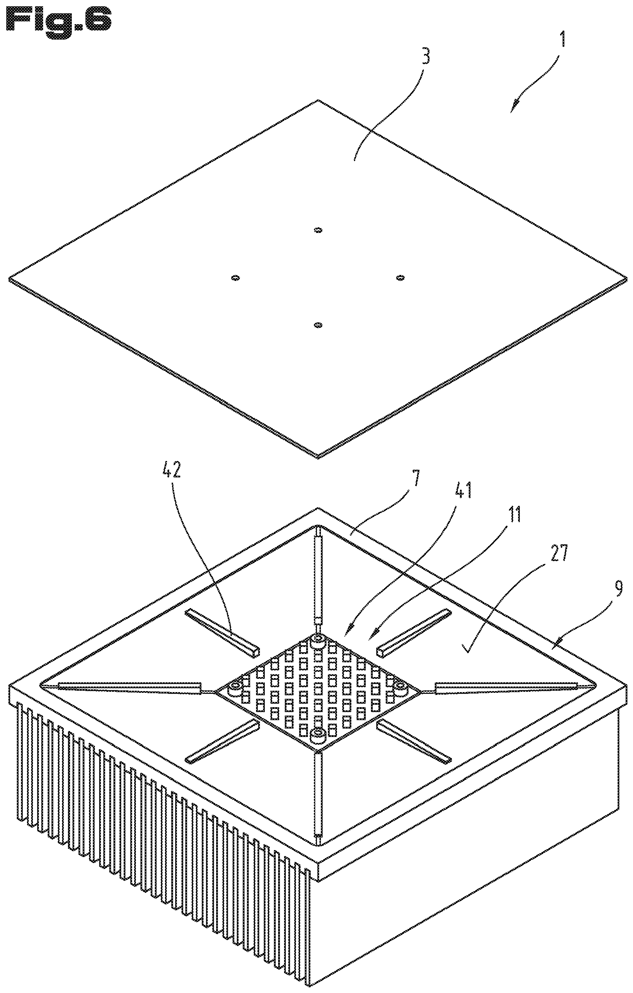

Wie aus Fig. 6 ersichtlich, kann vorgesehen sein, dass im Vertiefungsboden 27 der Vertiefung 9 eine Senke 41 ausgebildet ist, welche im Bereich des Kondensators 12 angeordnet ist. In der vorgesehenen Einbaulage des Luftwärmetauschers 1 weist die Senke 41 im Bereich des Verdampfers 11 ihren tiefsten Punkt auf.

Wie aus Fig. 6 weiters ersichtlich, kann vorgesehen sein, dass die Senke 41 und somit der Verdampfer 11 im Zentrum der Wärmetauscherplatte 7 angeordnet ist. Den Verdampfer 11 umgebend ist somit der Kondensator 12 ausgebildet. Weiters können Stützstege 42 vorgesehen sein, welche zur Abstützung der Trägerplatte an der Wärmetauscherplatte 7 dienen.

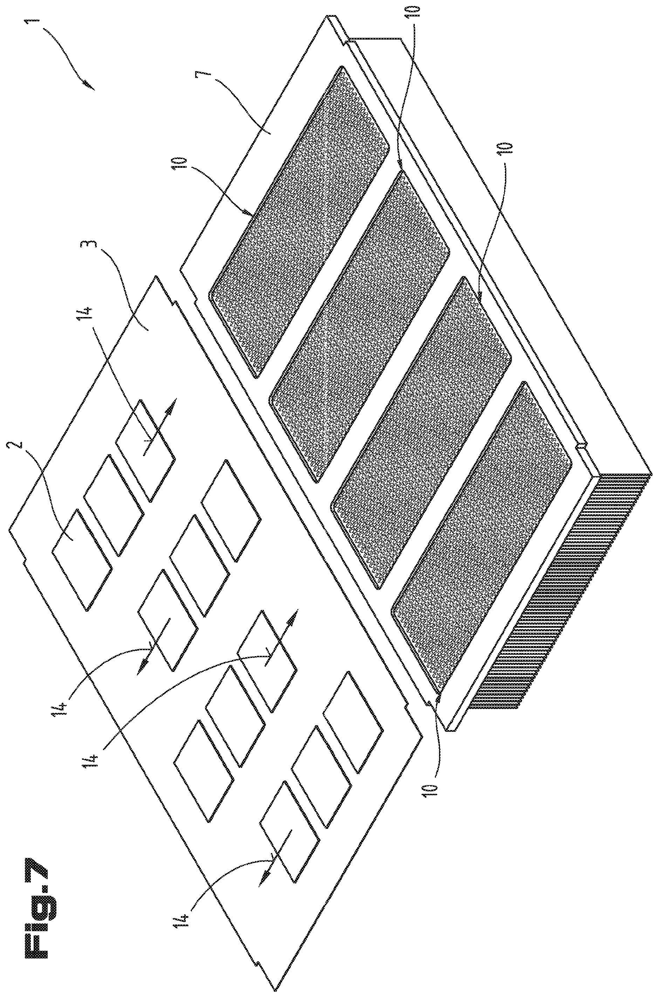

Wie aus Fig. 7 ersichtlich, kann vorgesehen sein, dass nebeneinander mehrere Hohlräume 10 ausgebildet sind, welche eine unterschiedliche bzw. gegensinnige Wärmetransportrichtung 14 aufweisen. Durch diese Maßnahme kann über die komplette Wärmetauscherplatte 7 gesehen eine homogene Temperaturverteilung erreicht werden.

Im Ausführungsbeispiel nach Fig. 7 sind die Leistungselektronikbauteile 2 in Form von Rechtecken an der Trägerplatte 3 schematisch angedeutet.

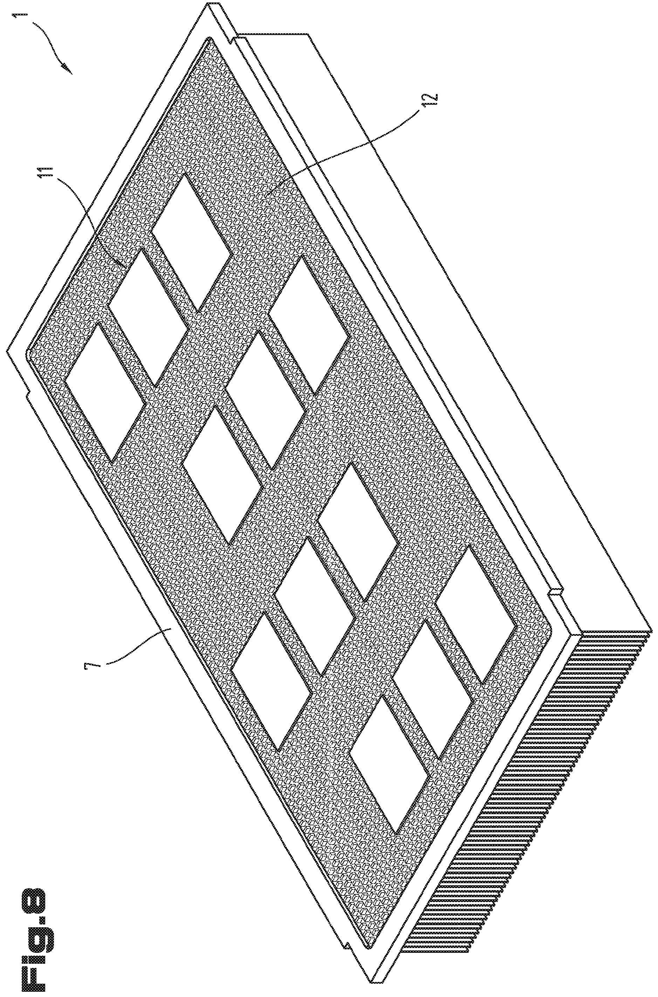

In Fig. 8 sind die Leistungselektronikbauteile 2 schematisch angedeutet, wobei die Trägerplatte 3 der Übersichtlichkeit halber ausgeblendet ist. Wie aus Fig. 8 ersichtlich, kann vorgesehen sein, dass nur ein einziger großer Hohlraum 10 ausgebildet ist, welcher mehrere Verdampfer 11 und mehrere Kondensatoren 12 aufweist. Die Verdampfer 11 sind hierbei jeweils im Bereich des Leistungselektronikbauteils 2 ausgebildet und die Kondensatoren 12 sind an der übrigen Fläche ausgebildet.

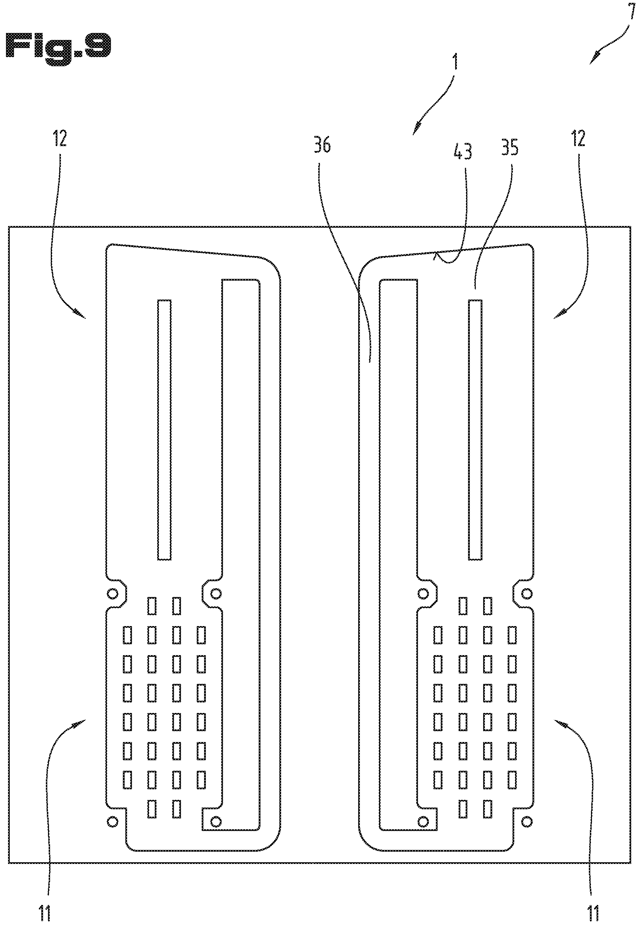

Das Ausführungsbeispiel nach Fig. 9 weist einen grundsätzlich ähnlichen Aufbau zum Ausführungsbeispiel nach Fig. 5 auf. Wie aus Fig. 9 ersichtlich, kann vorgesehen sein, dass der Luftwärmetauscher 1 eine stehende Anordnung aufweist, sodass im betriebsbereiten Zustand des Luftwärmetauschers 1 der Verdampfer 11 unterhalb des Kondensators 12 ausgebildet ist, wodurch das Arbeitsmedium 13 durch Einwirkung der Schwerkraft vom Kondensator 12 in den Verdampfer 11 gelangen kann. Eine Hohlraumseitenfläche 43 des Hohlraumes 10 weist beim Ausführungsbeispiel nach Fig. 9 ein Gefälle vom Dampfströmungskanal 35 zum Flüssigkeitsrückführkanal 36 hin auf, wodurch das an der Hohlraumseitenfläche 43 kondensierte Arbeitsmedium 13 schwerkraftgebunden in den Flüssigkeitsrückführkanal 36 läuft.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

| | | | |
|---|---|---|---|
| 1 | Luftwärmetauscher | 30 | Abstandhalter |
| 2 | Leistungselektronikbauteil | 31 | Längserstreckung Steg |
| 3 | Trägerplatte | 32 | Quererstreckung Steg |
| 4 | Aufnahmebereich | 33 | Längserstreckung Abstandhalter |
| 5 | Aufnahmeseite | 34 | Quererstreckung Abstandhalter |
| 6 | Trägerplattenanschlussfläche | 35 | Dampfströmungskanal |
| 7 | Wärmetauscherplatte | 36 | Flüssigkeitsrückführkanal |
| 8 | Wärmetauscherplattenanschlussfläche | 37 | Trennsteg |
| | | 38 | Öffnung |
| 9 | Vertiefung | 39 | Sockel |
| 10 | Hohlraum | 40 | Befüllöffnung |
| 11 | Verdampfer | 41 | Senke |
| 12 | Kondensator | 42 | Stützsteg |
| 13 | Arbeitsmedium | 43 | Hohlraumseitenfläche |
| 14 | Wärmetransportrichtung | | |
| 15 | Kühlrippe | | |
| 16 | Kühlrippenaufnahme | | |
| 17 | Querrichtung | | |
| 18 | Kühlrippenabstand | | |
| 19 | Kühlrippendicke | | |
| 20 | Kühlrippenüberstand | | |
| 21 | Kühlrippentiefe | | |
| 22 | Trägerplattenstärke | | |
| 23 | Wärmetauscherplattenstärke | | |
| 24 | Gewindeelement | | |
| 25 | Durchgangsloch | | |
| 26 | Steg | | |
| 27 | Vertiefungsboden | | |
| 28 | Reihe | | |
| 29 | weiteres Elektronikbauteil | | |

## Patentansprüche

1. Luftwärmetauscher (1) zur Kühlung eines Leistungselektronikbauteils (2) umfassend:
- eine Trägerplatte (3) mit einem Aufnahmebereich (4) zur Aufnahme des Leistungselektronikbauteils (2);
- eine Wärmetauscherplatte (7), welche mit der Trägerplatte (3) gekoppelt ist, wobei durch die Trägerplatte (3) und die Wärmetauscherplatte (7) zumindest teilweise begrenzt zumindest ein hermetisch abgeschlossener Hohlraum (10) zur Aufnahme eines Arbeitsmediums (13) ausgebildet ist, wobei der Hohlraum (10) einen Verdampfer (11) und einen Kondensator (12) aufweist, wobei der Verdampfer (11) in einer Wärmetransportrichtung (14) zum Kondensator (12) beabstandet angeordnet ist;
- Kühlrippen (15), welche mit der Wärmetauscherplatte (7) gekoppelt sind,
wobei die Trägerplatte (3) eine Trägerplattenanschlussfläche (6) aufweist und die Wärmetauscherplatte (7) eine Wärmetauscherplattenanschlussfläche (8) aufweist,
wobei
die Trägerplattenanschlussfläche (6) und die Wärmetauscherplattenanschlussfläche (8) aneinander anliegen,
wobei in der Wärmetauscherplattenanschlussfläche (8) der Wärmetauscherplatte (7) eine Vertiefung (9) ausgebildet ist, welche im zusammengebauten Zustand der Trägerplatte (3) und der Wärmetauscherplatte (7) einen hermetisch abgeschlossenen Hohlraum (10) bildet,
**dadurch gekennzeichnet, dass** die Trägerplattenanschlussfläche (6) und die Wärmetauscherplattenanschlussfläche (8) durch eine stoffschlüssige Verbindung miteinander gekoppelt sind, und dass im Bereich des Verdampfers (11) ein oder mehrere Stege (26) angeordnet sind, welche sich zwischen dem Vertiefungsboden (27) der Vertiefung (9) und der Wärmetauscherplattenanschlussfläche (8) erstrecken, wobei die Stege (26) im Zusammengebauten Zustand des Luftwärmetauschers (1) an der Trägerplattenanschlussfläche (6) der Trägerplatte (3) anliegen.

2. Luftwärmetauscher (1) nach Anspruch 1, **dadurch gekennzeichnet, dass** die Trägerplattenanschlussfläche (6) und die Wärmetauscherplattenanschlussfläche (8) jeweils als ebene Flächen ausgebildet sind.

3. Luftwärmetauscher (1) einem der vorhergehenden Ansprüche, **dadurch gekennzeichnet, dass** die Trägerplattenanschlussfläche (6) und die Wärmetauscherplattenanschlussfläche (8) durch eine eine Vakuumlötverbindung miteinander gekoppelt sind.

4. Luftwärmetauscher (1) nach einem der vorhergehenden Ansprüche, **dadurch gekennzeichnet, dass** mehrere der Stege (26) in einer Reihe (28) angeordnet sind, wobei mehrere Reihen (28) von Stegen (26) hintereinander angeordnet sind.

5. Luftwärmetauscher (1) nach Anspruch 4, **dadurch gekennzeichnet, dass** die einzelnen Stege (26) aus einer Reihe (28) und/oder aus unterschiedlichen Reihen (28) eine zueinander unterschiedliche Dimensionierung aufweisen und/oder dass die einzelnen Stege (26) in unterschiedlichen Abständen zueinander angeordnet sind.

6. Luftwärmetauscher (1) nach einem der vorhergehenden Ansprüche, **dadurch gekennzeichnet, dass** in der Wärmetauscherplatte (7) Kühlrippenaufnahmen (16) ausgebildet sind, in welchen die Kühlrippen (15) aufgenommen sind.

7. Luftwärmetauscher (1) nach einem der Ansprüche 1 bis 5, **dadurch gekennzeichnet, dass** Kühlrippen (15) einteilig an die Wärmetauscherplatte (7) angeformt sind.

8. Luftwärmetauscher (1) nach einem der vorhergehenden Ansprüche, **dadurch gekennzeichnet, dass** der Verdampfer (11) im Aufnahmebereich (4) angeordnet ist, wobei der Aufnahmebereich (4) in Draufsicht gesehen außermittig der Trägerplatte (3) angeordnet ist.

9. Luftwärmetauscher (1) nach einem der vorhergehenden Ansprüche, **dadurch gekennzeichnet, dass** der Hohlraum (10) den Verdampfer (11) und mehrere der Kondensatoren (12) aufweist, wobei mehrere Wärmetransportrichtungen (14) ausgebildet sind.

10. Luftwärmetauscher (1) nach einem der vorhergehenden Ansprüche, **dadurch gekennzeichnet, dass** eine Trägerplattenstärke (22) zwischen 2% und 300%, insbesondere zwischen 5% und 70%, bevorzugt zwischen 15% und 30% einer Wärmetauscherplattenstärke (23) beträgt.

11. Luftwärmetauscher (1) nach einem der vorhergehenden Ansprüche, **dadurch gekennzeichnet, dass** die Kühlrippen (15) derart angeordnet sind, dass die Längserstreckung der Kühlrippen (15) in Draufsicht auf die Wärmetauscherplattenanschlussfläche (8) gesehen quer zur Wärmetransportrichtung (14) ausgebildet ist.

12. Luftwärmetauscher (1) nach einem der vorhergehenden Ansprüche, **dadurch gekennzeichnet, dass** der Hohlraum (10) einen Dampfströmungskanal (35) und baulich davon beabstandet einen Flüssigkeitsrückführkanal (36) aufweist.

13. Luftwärmetauscher (1) nach Anspruch 12, **dadurch gekennzeichnet, dass** eine poröse Struktur oder ein Docht im Flüssigkeitsrückführkanal (36) angeordnet ist.

14. Luftwärmetauscher (1) nach einem der vorhergehenden Ansprüche, **dadurch gekennzeichnet, dass** in einem Vertiefungsboden (27) der Vertiefung (9) eine Senke (41) ausgebildet ist, welche ihren tiefsten Punkt im Bereich des Verdampfers (11) aufweist.

15. Luftwärmetauscher (1) nach einem der vorhergehenden Ansprüche, **dadurch gekennzeichnet, dass** in einem Hohlraum (10) mehrere Verdampfer (11) und/oder mehrere Kondensatoren (12) ausgebildet sind.

16. Luftwärmetauscher (1) nach einem der vorhergehenden Ansprüche, **dadurch gekennzeichnet, dass** zumindest zwei Hohlräume (10) nebeneinander angeordnet sind, wobei die zumindest zwei Hohlräume (10) eine zueinander gegensinnige Wärmetransportrichtung (14) aufweisen.

17. Luftwärmetauscher (1) nach einem der vorhergehenden Ansprüche, **dadurch gekennzeichnet, dass** in der Trägerplatte (3) oder in der Wärmetauscherplatte (7) eine mit dem Hohlraum (10) strömungsverbundene Befüllöffnung (40) ausgebildet ist, wobei die Befüllöffnung (40) im verbauten Zustand des Luftwärmetauschers (1) derart verpresst ist, dass sie dicht abgeschlossen ist.

18. Elektronikaufbau umfassend:
- einen Luftwärmetauscher (1);
- ein am Luftwärmetauscher (1) angeordnetes Leistungselektronikbauteil (2), insbesondere einen Bipolartransistor mit isolierter Gate-Elektrode;
**dadurch gekennzeichnet, dass**
der Luftwärmetauscher (1) nach einem der vorhergehenden Ansprüche ausgebildet ist.

19. Elektronikaufbau nach Anspruch 18, **dadurch gekennzeichnet, dass** das Leistungselektronikbauteil (2) im Bereich des Verdampfers (11) am Luftwärmetauscher (1) angeordnet ist und dass im Bereich des Kondensators (12) ein weiteres Elektronikbauteil (29) angeordnet ist, wobei das weitere Elektronikbauteil (29) eine geringere Wärmeabgabeleistung aufweist als eine Wärmeabgabeleistung des Leistungselektronikbauteils (2).

20. Elektronikaufbau nach Anspruch 18 oder 19, **dadurch gekennzeichnet, dass** in der Trägerplatte (3) eine Öffnung (38) ausgebildet ist, wobei das Leistungselektronikbauteil (2) derart an der Trägerplatte (3) befestigt ist, dass ein Sockel (39) des Leistungselektronikbauteils (2) die Ausnehmung verschließt und den Hohlraum (10) begrenzt.

21. Verfahren zum Herstellen eines Luftwärmetauschers (1), insbesondere eines Luftwärmetauschers (1) nach einem der vorhergehenden Ansprüche, **gekennzeichnet durch** die Verfahrensschritte:
- Verbinden einer Trägerplatte (3) mit einer Wärmetauscherplatte (7), wobei die Trägerplatte (3) eine Trägerplattenanschlussfläche (6) aufweist und die Wärmetauscherplatte (7) eine Wärmetauscherplattenanschlussfläche (8) aufweist, wobei die Trägerplattenanschlussfläche (6) und die Wärmetauscherplattenanschlussfläche (8) aneinander angelegt werden, wobei die Trägerplattenanschlussfläche (6) und die Wärmetauscherplattenanschlussfläche (8) durch eine stoffschlüssige Verbindung miteinander gekoppelt werden, wobei in der Wärmetauscherplattenanschlussfläche (8) der Wärmetauscherplatte (7) eine Vertiefung (9) ausgebildet ist, welche im zusammengebauten Zustand der Trägerplatte (3) und der Wärmetauscherplatte (7) einen hermetisch abgeschlossenen Hohlraum (10) bildet,
wobei im Bereich des Verdampfers (11) ein oder mehrere Stege (26) angeordnet sind, welche sich zwischen dem Vertiefungsboden (27) der Vertiefung (9) und der Wärmetauscherplattenanschlussfläche (8) erstrecken, wobei die Stege (26) im Zusammengebauten Zustand des Luftwärmetauschers (1) an der Trägerplattenanschlussfläche (6) der Trägerplatte (3) anliegen;
- Befüllen eines Hohlraumes (10) mit einem Arbeitsmedium (13) via die Befüllöffnung (40);
- Einstellen des gewünschten Druckes im Hohlraum (10);
- Hermetisches verschließen des Hohlraumes (10) durch Verpressen der Befüllöffnung (40).

## Claims

1. An air heat exchanger (1) for cooling a power electronics component (2), comprising:
- a carrier plate (3) having an accommodating region (4) for accommodating the power electronics component (2);
- a heat exchanger plate (7) which is coupled to the carrier plate (3), wherein at least one hermetically sealed cavity (10) for accommodating a working medium (13) is formed and at least partly delimited by the carrier plate (3) and the heat exchanger plate (7), wherein the cavity (10) comprises an evaporator (11) and a condenser (12), wherein the evaporator (11) is arranged so as to be spaced apart from the condenser (12) in a heat transport direction (14);
- cooling ribs (15) which are coupled to the heat exchanger plate (7),
wherein the carrier plate (3) has a carrier plate connecting surface (6) and the heat exchanger plate (7) has a heat exchanger plate connecting surface (8),
wherein
the carrier plate connecting surface (6) and the heat exchanger plate connecting surface (8) abut on one another,
wherein a recess (9) is formed in the heat exchanger plate connecting surface (8) of the heat exchanger plate (7), which recess (9), in the assembled state of the carrier plate (3) and the heat exchanger plate (7), forms a hermetically sealed cavity (10),
**characterized in that** the carrier plate connecting surface (6) and the heat exchanger plate connecting surface (8) are coupled to one another by a materially bonded connection, and that one or multiple webs (26), which extend between the recess base (27) of the recess (9) and the heat exchanger plate connecting surface (8), are arranged in the region of the evaporator (11), wherein the webs (26), in the assembled state of the air heat exchanger (1), abut on the carrier plate connecting surface (6) of the carrier plate (3).

2. The air heat exchanger (1) according to claim 1, **characterized in that** the carrier plate connecting surface (6) and the heat exchanger plate connecting surface (8) are each formed as planar surfaces.

3. The air heat exchanger (1) according to one of the preceding claims, **characterized in that** the carrier plate connecting surface (6) and the heat exchanger plate connecting surface (8) are coupled to one another by a vacuum brazing connection.

4. The air heat exchanger (1) according to one of the preceding claims, **characterized in that** multiple ones of the webs (26) are arranged in a row (28), wherein multiple rows (28) of webs (26) are arranged behind one another.

5. The air heat exchanger (1) according to claim 4, **characterized in that** the individual webs (26) of one row (28) and/or of different rows (28) have a dimensioning differing from one another and/or that the individual webs (26) are arranged at different distances from one another.

6. The air heat exchanger (1) according to one of the preceding claims, **characterized in that** cooling rib receptacles (16), in which the cooling ribs (15) are received, are formed in the heat exchanger plate (7).

7. The air heat exchanger (1) according to one of claims 1 to 5, **characterized in that** cooling ribs (15) are formed in one piece with the heat exchanger plate (7).

8. The air heat exchanger (1) according to one of the preceding claims, **characterized in that** the evaporator (11) is arranged in the accommodating region (4), wherein the accommodating region (4) is arranged off-center of the carrier plate (3) as seen in top view.

9. The air heat exchanger (1) according to one of the preceding claims, **characterized in that** the cavity (10) comprises the evaporator (11) and multiple ones of the condensers (12), wherein multiple heat transport directions (14) are formed.

10. The air heat exchanger (1) according to one of the preceding claims, **characterized in that** a carrier plate thickness (22) amounts to between 2% and 300%, in particular between 5% and 70%, preferably between 15% and 30% of a heat exchanger plate thickness (23).

11. The air heat exchanger (1) according to one of the preceding claims, **characterized in that** the cooling ribs (15) are arranged such that the longitudinal extension of the cooling ribs (15) as seen in top view onto the heat exchanger plate connecting surface (8) are formed transversely to the heat transport direction (14).

12. The air heat exchanger (1) according to one of the preceding claims, **characterized in that** the cavity (10) comprises a vapor flow channel (35) and a liquid return channel (36) at a constructional distance therefrom.

13. The air heat exchanger (1) according to claim 12, **characterized in that** a porous structure or a wick is arranged in the liquid return channel (36).

14. The air heat exchanger (1) according to one of the preceding claims, **characterized in that** a depression (41), which has its deepest point in the region of the evaporator (11), is formed in a recess base (27) of the recess (9).

15. The air heat exchanger (1) according to one of the preceding claims, **characterized in that** multiple evaporators (11) and/or multiple condensers (12) are formed in a cavity (10).

16. The air heat exchanger (1) according to one of the preceding claims, **characterized in that** the at least two cavities (10) are arranged next to one another, wherein the at least two cavities (10) have opposite heat transport directions (14).

17. The air heat exchanger (1) according to one of the preceding claims, **characterized in that** a filling opening (40) that is in flow connection with the cavity (10) is formed in the carrier plate (3) or in the heat exchanger plate (7), wherein the filling opening (40) in the installed state of the air heat exchanger (1) is pressed in such a way that it is tightly sealed.

18. An electronic assembly comprising:
- an air heat exchanger (1);
- a power electronics component (2), in particular an insulated-gate bipolar transistor, arranged on the air heat exchanger (1);
**characterized in that**
the air heat exchanger (1) is formed according to one of the preceding claims.

19. The electronic assembly according to claim 18, **characterized in that** the power electronics component (2) is arranged in the region of the evaporator (11) of the air heat exchanger (1) and that a further electronic component (29) is arranged in the region of the condenser (12), wherein the further electronic component (29) has a lower heat dissipation performance than a heat dissipation performance of the power electronics component (2).

20. The electronic assembly according to claim 18 or 19, **characterized in that** an opening (38) is formed in the carrier plate (3), wherein the power electronics component (2) is mounted on the carrier plate (3) such that a footing (39) of the power electronics component (2) closes the recess and delimits the cavity (10).

21. A method for producing an air heat exchanger (1) according to one of the preceding claims, **characterized by** the method steps:
- connecting a carrier plate (3) to a heat exchanger plate (7), wherein the carrier plate (3) has a carrier plate connecting surface (6) and the heat exchanger plate (7) has a heat exchanger plate connecting surface (8), wherein the carrier plate connecting surface (6) and the heat exchanger plate connecting surface (8) abut on one another, wherein the carrier plate connecting surface (6) and the heat exchanger plate connecting surface (8) are coupled to one another by a materially bonded connection,
wherein a recess (9) is formed in the heat exchanger plate connecting surface (8) of the heat exchanger plate (7), which recess (9), in the assembled state of the carrier plate (3) and the heat exchanger plate (7), forms a hermetically sealed cavity (10),
wherein one or multiple webs (26), which extend between the recess base (27) of the recess (9) and the heat exchanger plate connecting surface (8), are arranged in the region of the evaporator (11), wherein the webs (26), in the assembled state of the air heat exchanger (1), abut on the carrier plate connecting surface (6) of the carrier plate (3);
- filling a cavity (10) with a working medium (13) via the filling opening (40);
- setting the desired pressure in the cavity (10);
- hermetically sealing the cavity (10) by pressing the filling opening (40).

## Revendications

1. Échangeur thermique à air (1) destiné au refroidissement d'un composant électronique de puissance (2), comprenant :
- une plaque de support (3) avec une zone de réception (4) destinée à recevoir le composant électronique de puissance (2) ;
- une plaque d'échangeur thermique (7) qui est couplée à la plaque de support (3), au moins une cavité hermétiquement fermée (10) destinée à recevoir un fluide de travail (13) étant formée au moins en partie par la plaque de support (3) et la plaque d'échangeur thermique (7), la cavité (10) présentant un évaporateur (11) et un condenseur (12), l'évaporateur (11) étant agencé à distance du condenseur (12) dans une direction de transport de chaleur (14) ;
- des ailettes de refroidissement (15) qui sont couplées à la plaque d'échangeur thermique (7),
la plaque de support (3) présentant une surface de raccordement de plaque de support (6) et la plaque d'échangeur thermique (7) présentant une surface de raccordement de plaque d'échangeur thermique (8),
la surface de raccordement de plaque de support (6) et la surface de raccordement de plaque d'échangeur thermique (8) étant adjacentes l'une à l'autre,
un renfoncement (9) étant formé dans la surface de raccordement (8) de la plaque d'échangeur thermique (7), lequel renfoncement forme, à l'état monté, une cavité hermétiquement fermée (10) entre la plaque de support (3) et la plaque d'échangeur thermique (7),
**caractérisé en ce que** la surface de raccordement de plaque de support (6) et la surface de raccordement de plaque d'échangeur thermique (8) sont couplées l'une à l'autre par une liaison par adhérence, et **en ce que**, dans la zone de l'évaporateur (11), une ou plusieurs nervures (26) sont agencées, lesquelles s'étendent entre le fond (27) du renfoncement (9) et la surface de raccordement de plaque d'échangeur thermique (8), les nervures (26) s'appuyant contre la surface de raccordement (6) de la plaque support (3) lorsque l'échangeur thermique à air (1) est à l'état monté.

2. Échangeur thermique à air (1) selon la revendication 1, **caractérisé en ce que** la surface de raccordement de plaque de support (6) et la surface de raccordement de plaque d'échangeur thermique (8) sont chacune conçues comme des surfaces planes.

3. Échangeur thermique à air (1) selon l'une des revendications précédentes, **caractérisé en ce que** la surface de raccordement de plaque de support (6) et la surface de raccordement de plaque d'échangeur thermique (8) sont couplées l'une à l'autre par une liaison par soudure sous vide.

4. Échangeur thermique à air (1) selon l'une des revendications précédentes, **caractérisé en ce que** plusieurs des nervures (26) sont agencées en une rangée (28), plusieurs rangées (28) de nervures (26) étant agencées les unes derrière les autres.

5. Échangeur thermique à air (1) selon la revendication 4, **caractérisé en ce que** les différentes nervures (26) d'une rangée (28) et/ou de différentes rangées (28) présentent des dimensions différentes les unes par rapport aux autres et/ou **en ce que** les différentes nervures (26) sont agencées à des distances différentes les unes des autres.

6. Échangeur thermique à air (1) selon l'une des revendications précédentes, **caractérisé en ce que** des logements pour ailettes de refroidissement (16) sont formés dans la plaque d'échangeur thermique (7), dans lesquels sont logées les ailettes de refroidissement (15).

7. Échangeur thermique à air (1) selon l'une des revendications 1 à 5, **caractérisé en ce que** les ailettes de refroidissement (15) sont moulées d'un seul tenant sur la plaque d'échangeur thermique (7).

8. Échangeur thermique à air (1) selon l'une des revendications précédentes, **caractérisé en ce que** l'évaporateur (11) est agencé dans la zone de réception (4), la zone de réception (4) étant agencée de manière excentrée par rapport à la plaque de support (3) vue en plan.

9. Échangeur thermique à air (1) selon l'une des revendications précédentes, **caractérisé en ce que** la cavité (10) comprend l'évaporateur (11) et plusieurs des condenseurs (12), plusieurs directions de transport de chaleur (14) étant formées.

10. Échangeur thermique à air (1) selon l'une des revendications précédentes, **caractérisé en ce que** l'épaisseur de la plaque de support (22) est comprise entre 2 % et 300 %, en particulier entre 5 % et 70 %, de préférence entre 15 % et 30 % de l'épaisseur de la plaque d'échangeur thermique (23).

11. Échangeur thermique à air (1) selon l'une des revendications précédentes, **caractérisé en ce que** les ailettes de refroidissement (15) sont agencées de telle sorte que l'extension longitudinale des ailettes de refroidissement (15) selon une vue en plan sur la surface de raccordement des plaques d'échangeur thermique (8), est formée transversalement à la direction de transport de chaleur (14).

12. Échangeur thermique à air (1) selon l'une des revendications précédentes, **caractérisé en ce que** la cavité (10) présente un canal d'écoulement de vapeur (35) et, à distance de celui-ci, un canal de retour de liquide (36).

13. Échangeur thermique à air (1) selon la revendication 12, **caractérisé en ce qu'**une structure poreuse ou une mèche est agencée dans le canal de retour de liquide (36).

14. Échangeur thermique à air (1) selon l'une des revendications précédentes, **caractérisé en ce qu'**un creux (41) est formé dans un fond (27) du renfoncement (9), lequel renfoncement présente son point le plus profond dans la zone de l'évaporateur (11).

15. Échangeur thermique à air (1) selon l'une des revendications précédentes, **caractérisé en ce que** plusieurs évaporateurs (11) et/ou plusieurs condenseurs (12) sont formés dans une cavité (10).

16. Échangeur thermique à air (1) selon l'une des revendications précédentes, **caractérisé en ce qu'**au moins deux cavités (10) sont agencées l'une à côté de l'autre, les au moins deux cavités (10) présentant des directions de transport de chaleur (14) opposées l'une à l'autre.

17. Échangeur thermique à air (1) selon l'une des revendications précédentes, **caractérisé en ce qu'**une ouverture de remplissage (40) reliée à la cavité (10) en termes de flux est formée dans la plaque de support (3) ou dans la plaque d'échangeur thermique (7), l'ouverture de remplissage (40) étant comprimée à l'état monté de l'échangeur thermique à air (1) de manière à être fermée de manière étanche.

18. Structure électronique comprenant :
- un échangeur thermique à air (1) ;
- un composant électronique de puissance (2) agencé sur l'échangeur thermique à air (1), en particulier un transistor bipolaire à électrode de grille isolée ;
**caractérisée en ce que**
l'échangeur thermique à air (1) est conçu selon l'une des revendications précédentes.

19. Structure électronique selon la revendication 18, **caractérisée en ce que** le composant électronique de puissance (2) est agencé dans la zone de l'évaporateur (11) sur l'échangeur thermique à air (1) et qu'un autre composant électronique (29) est agencé dans la zone du condenseur (12), l'autre composant électronique (29) présentant une puissance de dissipation thermique inférieure à la puissance de dissipation thermique du composant électronique de puissance (2).

20. Structure électronique selon la revendication 18 ou 19, **caractérisé en ce qu'**une ouverture (38) est formée dans la plaque de support (3), le composant électronique de puissance (2) étant fixé à la plaque de support (3) de telle sorte qu'un socle (39) du composant électronique de puissance (2) ferme l'évidement et délimite la cavité (10).

21. Procédé de fabrication d'un échangeur thermique à air (1), en particulier d'un échangeur thermique à air (1) selon l'une des revendications précédentes, **caractérisé par** les étapes de procédure suivantes :
- Assemblage d'une plaque de support (3) avec une plaque d'échangeur thermique (7), la plaque de support (3) présentant une surface de raccordement de plaque de support (6) et la plaque d'échangeur thermique (7) présentant une surface de raccordement de plaque d'échangeur thermique (8), la surface de raccordement de plaque de support (6) et la surface de raccordement de plaque d'échangeur thermique (8) étant appliquées l'une contre l'autre, la surface de raccordement de plaque de support (6) et la surface de raccordement de plaque d'échangeur thermique (8) étant couplées l'une à l'autre par une liaison par adhérence, un renfoncement (9) étant formé dans la surface de raccordement (8) de la plaque d'échangeur thermique (7), lequel renfoncement formant une cavité hermétiquement fermée (10) lorsque la plaque de support (3) et la plaque d'échangeur thermique (7) sont à l'état monté,
une ou plusieurs nervures (26) étant agencées dans la zone de l'évaporateur (11), lesquelles s'étendent entre le fond (27) du renfoncement (9) et la surface de raccordement de plaque d'échangeur thermique (8), les nervures (26) s'appuyant contre la surface de raccordement (6) de la plaque de support (3) lorsque l'échangeur thermique à air (1) est à l'état monté ;
- Remplissage d'une cavité (10) avec un fluide de travail (13) via l'ouverture de remplissage (40) ;
- Réglage de la pression souhaitée dans la cavité (10) ;
- Fermeture hermétique de la cavité (10) par compression de l'ouverture de remplissage (40).
